# EUROPÄISCHE PATENTSCHRIFT

(11) **EP 0 689 291 B1**
(45) Veröffentlichungstag und Bekanntmachung des Hinweises auf die Patenterteilung: **18.03.1998**
(21) Anmeldenummer: 95108371.6
(22) Anmeldetag: 01.06.1995
(51) Int. Cl.: H03K 17/16, H03K 17/687, H03K 19/003, H03K 19/00

(54) **MOS-Treiberschaltung**
MOS driver circuit
Circuit d'attaque du type MOS

(30) Priorität: 18.06.1994 DE 4421419
(43) Veröffentlichungstag der Anmeldung: 27.12.1995
(73) Patentinhaber: Micronas Intermetall GmbH, 79108 Freiburg (DE)
(72) Erfinder: Giebel, Burkhard, Dipl.-Ing., D-79211 Denzlingen (DE)

(56) Entgegenhaltungen:
- EP-A- 0 282 981
- DE-A- 4 109 146

## Beschreibung

Die Erfindung betrifft eine MOS-Treiberschaltung mit einem ersten von einer ersten Treiberstufe und einem von einer zweiten Treiberstufe im Gegentakt in einen leitenden bzw. nicht leitenden Zustand gesteuerten Ausgangstransistor, an deren Verbindungspunkt eine zu treibende Last anschließbar ist, wobei zwischen einem Dateneingang und der ersten Treiberstufe eine erste Haltestufe und zwischen dem Dateneingang und der zweiten Treiberstufe eine zweite Haltestufe geschaltet sind, wobei die erste Haltestufe aufgrund eines von der zweiten Treiberstufe gelieferten Enable-Signals ein von dem Dateneingang kommendes Datensignal an die erste Treiberstufe weitergibt, und die zweite Haltestufe aufgrund eines von der ersten Treiberstufe gelieferten Enable-Signals das von dem Dateneingang kommende Datensignal an die zweite Treiberstufe weitergibt.

Eine derartige Treiberschaltung ist aus der DE-C-37 08 499 bekannt. Sie wird typischerweise als Ausgangsstufe von logischen Schaltung in CMOS-Technik verwendet, welche zum Antreiben von Lasten dienen. Bei solchen Treiberschaltungen müssen steile Impulsflanken verhindert werden, da sie aufgrund ihrer hohen Frequenzanteile zu Störstrahlung führen können. Daher werden die Ausgangstransistoren von den Treiberstufen derart in den leitenden bzw. nicht leitenden Zustand gesteuert, daß der Übergang kontinuierlich, d.h. nicht rechteckförmig erfolgt sondern mit einer deutlich begrenzten Flankensteilheit. Zu diesem Zweck werden hochohmige Treiberstufen verwendet.

Eine derartige Treiberschaltung hat den Nachteil, daß beim Treiben von störungsbelasteten Ausgängen in der Betriebsphase, in der die Ausgangstransistoren stationär in dem leitenden bzw. nichtleitenden Zustand gehalten werden, ein Querstrom zwischen den Ausgangstransistoren auftreten kann. Dies rührt daher, daß sich bei einer externen Störung die Spannung am Drainanschluß des Ausgangstransistors, der sich in dem nichtleitenden Zustand befindet, ändert. Da zwischen dem Drain und dem Gate des Transistors stets ein parasitärer Kondensator vorhanden ist, entsteht am Gate des Transistors ebenfalls eine Spannungsänderung. Diese Spannungsänderung kann bewirken, daß der Transistor in einen leitenden Zustand übergeführt wird, so daß zwischen den Transistoren ein Querstrom fließt. Externe Störungen können auf einen Ausgang gelangen, z.B. durch kapazitive und induktive Einkoppelungen von Nachbarsignalen, die z.B. im Gehäuse des IC, auf der Schaltplatine oder in einem Kabelbaum verlaufen.

Der Erfindung liegt die Aufgabe zugrunde, eine MOS-Treiberschaltung zu schaffen, bei welcher beim Treiben ohmscher, kapazitiver und induktiver Lasten jegliche Querströme zwischen den Ausgangstransistoren verhindert werden. Solche Querströme sind Quelle unnötiger Verlustleistung und unnötiger elektromagnetischer Abstrahlung.

Diese Aufgabe wird durch eine gattungsgemäße MOS-Treiberschaltung gelöst, bei der die erste und die zweite Treiberstufe jeweils ein niederohmiges und ein hochohmiges Treiberelement umfassen, wobei die hochohmigen Treiberelemente die Ausgangstransistoren in den leitenden bzw. nichtleitenden Zustand überführen und die niederohmigen Treiberelemente die Ausgangstransistoren im nichtleitenden Zustand halten.

Es gibt also gemäß der Erfindung zwei getrennte Schaltungen für den Übergang des Ausgangs und für den stationären Betrieb der Treiberschaltung. Durch das erfindungsgemäße Aufteilen der Treiberstufen in jeweils ein hochohmiges und ein niederohmiges Treiberelement wird erreicht, daß das Überführen der Ausgangstransistoren in den leitenden bzw. nichtleitenden Zustand kontinuierlich, das heißt mit einer deutlich begrenzten Flankensteilheit erfolgt, und trotzdem nach Erreichen des nichtleitenden Zustands eines Ausgangstransistors ein Querstrom zwischen den beiden Transistoren zuverlässig verhindert wird, auch wenn der Ausgang Störeinflüssen unterliegt. Denn die niederohmigen Treiberelemente halten das Gate des jeweiligen Ausgangstransistors niederohmig auf einer festen Spannung. Folglich wird der Zustand des Transistors nicht von einem am Ausgang der Schaltung auftretenden Impuls beeinflußt, welcher durch den zwischen Drain und Gate parasitär vorhandenen Millerkondensator auf das Gate übertragen wird. Der Ausgangstransistor bleibt zuverlässig im nichtleitenden Zustand.

Es ist günstig, wenn die erste bzw. zweite Haltestufe das Datensignal derart an die erste bzw. zweite Treiberstufe weitergibt, daß der erste bzw. zweite Ausgangstransistor erst dann in den leitenden Zustand übergeführt wird, wenn der zweite bzw. erste Ausgangstransistor den gesperrten Zustand erreicht hat. Dadurch wird verhindert, daß während der Zustandsänderung des Ausganges ein Querstrom durch die Transistoren fließt. Gemäß einem günstigen Ausführungsbeispiel der Erfindung wird zwischen einem Ausgang der ersten bzw. zweiten Treiberstufe und einem Eingang für ein Enable-Signal der zweiten bzw. ersten Haltestufe ein Schwellenelement vorgesehen, welches das Enable-Signal bei Erreichen eines bestimmten Spannungspegels der zweiten bzw. ersten Haltestufe zuführt, wenn der erste/zweite Ausgangstransistor in den nichtleitenden bzw. der zweite/erste Ausgangstransistor in den leitenden Zustand übergeführt werden sollen. Diese Ausführung der Querstromverhinderung in den Ausgangstransistoren ist technisch einfach herstellbar und ermöglicht eine genau arbeitende Ablaufsteuerung, die ohne analoge Zeitverzögerungselemente auskommt.

Vorteilhafterweise können die Halteschaltungen jeweils als ein Flipflop enthalten. Mit den Flipflops kann die jeweilige Treiberstufe in dem niederohmigen Zustand verriegelt werden, nachdem nach einer Eingangssignal-Änderung an dem Eingang E die auf hochohmig geschalteten Treiberstufen den Zustandswechsel am Ausgang A bewerkstelligt haben.

Gemäß einer vorteilhaften Weiterbildung der Erfindung kann an je einem Eingang der niederohmigen Treiberelemente das Datensignal anliegen und einem Enable-Eingang des niederohmigen Treiberelements der ersten bzw. zweiten Treiberstufe das Ausgangssignal der zweiten bzw. ersten Haltestufe so zugeführt werden, daß es das jeweilige niederohmige Treiberelement einschaltet, nachdem der jeweilige Ausgangstransistor in den leitenden Zustand übergeführt ist. So wird auf zuverlässige und einfache Art gewährleistet, daß die niederohmigen Treiberelemente die Haltefunktion der Ausgangstransistoren in dem leitenden Zustand erst dann übernehmen, wenn der Zustandswechsel des Ausganges abgeschlossen ist. Günstigerweise kann das Datensignal bei einem Wechsel seines Zustandes das jeweilige niederohmige Treiberelement abschalten, bevor die Ausgangstransistoren durch die hochohmigen Treiberelemente in den leitenden bzw. nichtleitenden d.h. in den jeweils anderen Zustand übergeführt werden.

Auch kann es vorteilhaft sein, wenn zwischen das Gate und das Drain eines Ausgangstransistors ein Kondensator geschaltet ist. Dies ist bei Anwendungsfällen, bei denen ein Kondensator mit höherer Kapazität als die des vorhandenen parasitären Kondensators zwischen Gate und Drain benötigt wird, vorteilhaft, wenn etwa die Gate-Ansteuerungs-Signale für die Ausgangstransistoren einen möglichst langsamen Anstieg bzw. Abfall haben sollen. Normalerweise würde ein derartiger Kondensator das Risiko des Auftretens von Querströmen durch die Transistoren bei Ausgangsstörungen erheblich vergrößern. Dies ist in der erfindungsgemäßen Anordnung jedoch unproblematisch, da auch in diesem Fall durch die niederohmige stationäre Ansteuerung das Auftreten solcher Querströme zuverlässig verhindert wird.

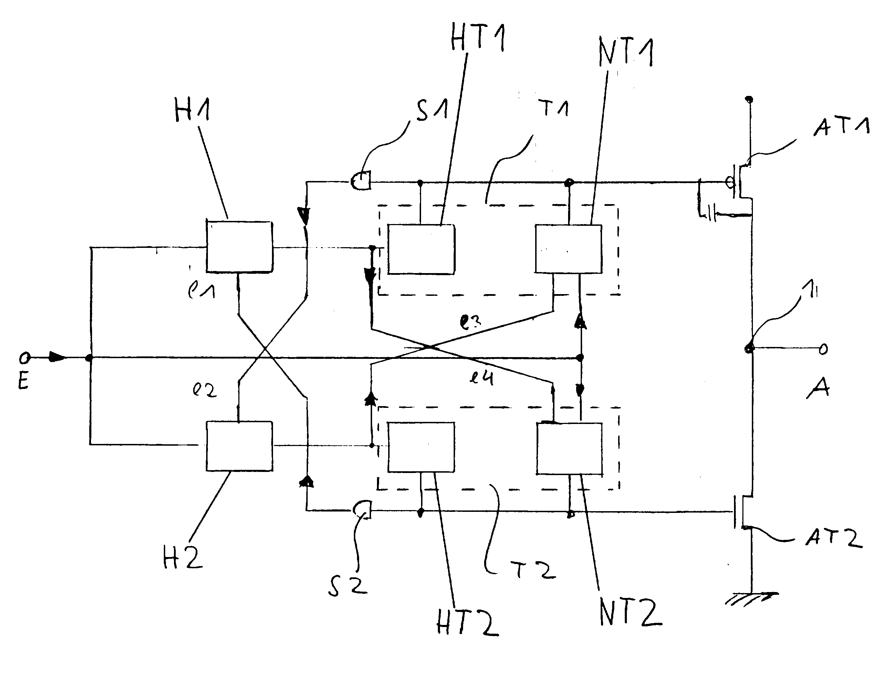

Im folgenden wird die Erfindung anhand der Figur näher erläutert.

Die Figur zeigt eine schematische Darstellung eines Ausführungsbeispiels der erfindungsgemäßen MOS-Treiberschaltung.

Die in der Figur dargestellte erfindungsgemäße MOS-Treiberschaltung weist einen ersten Ausgangstransistor AT1 und einen zweiten Ausgangstransistor AT2 auf. An einem Verbindungspunkt 1 der Ausgangstransistoren AT1, AT2 befindet sich ein Ausgang A, an dem eine zu treibende Last angeschlossen werden kann. Die Transistoren AT1, AT2 werden mit einem an einem Dateneingang E liegenden Datensignal über Halteschaltungen H1, H2 und Treiberstufen T1, T2 im Gegentakt in einen leitenden bzw. nichleitenden Zustand gesteuert. In dem gezeigten Ausführungsbeispiel wird für den ersten, zwischen der postiven Spannungsversorgung und dem Verbindungspunkt 1 liegenden Ausgangstransistor AT1 ein p-Kanal-Transistor und für den zweiten, zwischen dem Verbindungspunkt 1 und der Masse liegenden Ausgangstransistor AT2 ein n-Kanal-Transistor verwendet. Das von dem Dateneingang E kommende Datensignal wird sowohl auf die erste Haltestufe H1 als auch auf die zweite Haltestufe H2 gegeben. Das Datensignal gelangt von der ersten Haltestufe H1 über die erste Treiberstufe T1 zu dem ersten Ausgangstransistor AT1 und von der zweiten Haltestufe H2 über die zweite Treiberstufe T2 zu dem zweiten Ausgangstransistor AT2. Die erste Treiberstufe T1 umfaßt ein erstes niederohmiges Treiberelement NT1 und ein erstes hochohmiges Treiberelement HT1, die zweite Treiberstufe T2 umfaßt ein zweites niederohmiges Treiberelement NT2 und ein zweites hochohmiges Treiberelement HT2. Mit den hochohmigen Treiberelementen HT1, HT2 werden die Ausgangstransistoren AT1, AT2 jeweils in den leitenden bzw. nichtleitenden Zustand übergeführt. Hierdurch wird bewirkt, daß das Umschalten der Ausgangstransistoren AT1, AT2 in den leitenden bzw. nichtleitenden Zustand langsam, d.h. unter Vermeidung steiler Pulsflanken, geschieht. Wenn der Ausgangstransistor AT1 oder AT2 den nichtleitenden Zustand erreicht hat, muß er in dieser Phase statisch gehalten werden. Dies geschieht mit den niederohmigen Treiberelementen NT1, NT2. Hierdurch werden Querströme zwischen den Ausgangstransistoren AT1, AT2 auch beim Auftreten von Ausgangsstörungen vermieden. Solche Querströme könnten wie beschrieben beim Halten des statischen, nichtleitenden Zustandes durch das hochhomige Treiberelement HT1 oder HT2 durch Störsignale am Ausgang A entstehen, da dies zu einer Spannungsänderung am Drain des jeweils nichtleitenden Transistors AT1 oder AT2 führen würde. Da zwischen dessen Drainanschluß und dessen Gate immer ein parasitärer Kondensator vorhanden ist, würde sich auch die Spannung an diesem Gate ändern. Dadurch kann dieser Transistor leitend werden, so daß zwischen beiden Transistoren ein Querstrom fließen würde. Diese Querströme werden durch das Halten der Ausgangstransistoren AT1, AT2 von den niederohmigen Treiberelementen NT1, NT2 verhindert, da diese die Gate-Spannung des entsprechenden Transistors AT1 oder AT2 niederohmig festlegen.

Das Umschalten der Ausgangstransistoren AT1, AT2 mit den hochohmigen Treiberelemten HT1, HT2 erfolgt derart, daß während der Ausgangs-Änderung ein gleichzeitiges Leiten der beiden Ausgangstransistoren AT1, AT2 sicher vermieden wird. Hierzu ist zwischen dem Ausgang des ersten hochohmigen Treiberelements HT1 und einem Eingang für das Enable-Signal e2 der zweiten Haltestufe H2 ein Schwellenelement S1 vorgesehen. Zwischen dem Ausgang des zweiten hochohmigen Treiberelements HT2 und einem Eingang für das Enable-Signal e1 der ersten Haltestufe H1 ist ein Schwellenelement S2 vorgesehen. Das Schwellenelement S1 gibt das Enable-Signal e2 erst bei Erreichen eines bestimmten Spannungspegels an die zweite Haltestufe H2 weiter. Somit erhält die Haltestufe H2 das Enable-Signal e2, aufgrund dessen das Datensignal von der zweiten Haltestufe H2 an das zweite hochohmige Treiberelement HT2 weitergegeben wird, erst dann, wenn der erste Ausgangstransistor AT1 bereits in den nichtleitenden Zustand übergeführt worden ist. Erst danach beginnt das zweite hochohmige Treiberelement HT2, den zweiten Ausgangstransistor AT2 in den leitenden Zustand überzuführen. Entsprechend führt das zweite Schwellenelement S2 das Enable-Signal el erst bei Erreichen eines bestimmten Spannungspegels der ersten Haltestufe H1 zu. In diesem Fall gibt die Haltestufe H1 das Signal zum Überführen des ersten Ausgangstransistors AT1 in den leitenden Zustand erst dann an das erste hochohmige Treiberelement HT1 weiter, wenn der zweite Ausgangstransistors AT2 den nichtleitenden Zustand erreicht hat.

Die Haltestufen H1, H2 können jeweils als ein Flipflop ausgebildet sein. Diese bistabilen Elemente werden so angesteuert, daß nach einem Wechsel des Eingangssignals zwar zunächst der Wechsel des Ausgangssignals durch Ansteuern der Ausgangstransistoren mit den hochohmigen Treiberelementen bewerkstelligt wird, dann jedoch der sperreiche Ausgangstransistor in der niederohmigen Ansteuerung verriegelt wird. Ein Zurückspringen in die hochohmige Ansteuerung, etwa nach einer externen Störung, wird so ausgeschlossen. Die Überführung des Ausgangstransistors AT1 in den nichtleitenden Zustand erfolgt durch direkte Weitergabe des Datensignals von der Haltestufe H1 an das hochohmige Treiberelement HT1 und das Überführen des Ausgangstransistors AT2 in den nichtleitenden Zustand erfolgt durch direkte Weitergabe des Datensignals von der Haltestufe H2 an das hochohmige Treiberelement HT2.

Die Ansteuerung des ersten niederohmigen Treiberelements NT1 erfolgt durch eine Verknüpfung des Datensignals und des von dem Ausgang der Haltestufe H2 kommende Enable-Signal e3. Entsprechend erfolgt das Ansteuern des zweiten niederohmigen Treiberelements durch eine Verknüpfung des Datensignals mit dem vom Ausgang der ersten Haltestufe H1 kommenden Enable-Signal e4. In dem gezeigten Ausführungsbeispiel werden, wenn der Zustand des Datensignals wechselt, die niederohmigen Treiberelemente NT1, NT2 abgeschaltet, bevor die Ausgangstransistoren AT1, AT2 in den anderen Zustand übergeführt werden. Hierzu liegt das Datensignal direkt an den niederohmigen Treiberelementen NT1, NT2 an. Die Realisierung der Schaltungsvorgänge erfolgt durch geeignete Anordnung von logischen Schaltelementen, wie sie dem Fachmann bekannt ist.

Alle beschriebenen Funktionen werden durch Verknüpfen von logischen Elementen bewirkt. Je nach Funktion werden logische UND-Gatter, ODER-Gatter und Inverter verwendet. Die Realisierung der hochohmigen und der niederohmigen Treiberelemente HT1, HT2, NT1, NT2 kann z.B. zwei im Gegentakt angesteuerte Transistoren enthalten. Von diesen ist typischerweise der an der positiven Versorgungsspannung angeschlossene Transistor ein p-Kanal-Transistor, und der an Masse angeschlossene Transistor ein n-Kanal-Transistor. Die Niederohmigkeit bzw. Hochohmigkeit der Treiberelemente HT1, HT2, NT1, NT2 kann durch geeignete Ausbildung der Transistoren erreicht werden. Für die hochohmigen Treiberelemente HT1, HT2 können Transistoren mit einem kleinen W/L-Verhältnis verwendet werden. Für die niederohmien Treiberelemente NT1, NT2 können entsprechend Transistoren mit einem großen W/L-Verhältnis verwendet werden. Der Unterschied zwischen den W/L-Verhältnissen der niederohmigen Treiberelemente NT1, NT2 zu den hochohmigen Treiberelementen HT1, HT2 kann typischerweise einen Faktor 10 bis 20 betragen; aber auch erheblich größere oder kleinere Faktoren können für den geweiligen Anwendungsfall sinnvoll sein.

In dem gezeigten Ausführungsbeispiel ist zwischen dem Gate und dem DrainAnschluß des ersten Ausgangstransistors AT1 ein mitintegrierter Kondensator vorgesehen. Dieser Kondensator ist zusätzlich zu dem parasitär vorhandenen Kondensator ausgebildet. Er ist so gewählt, daß die Gesamt-Miller-Kapazität des p-Kanal-Ausgangstransistors auf einen Wert gebracht wird, der für die Erzeugung einer langsamen Gate-Ansteuerung für den p-Kanal-Transistor eher geeignet ist, als die parasitäre Gate-Drain-Kapazität alleine.

## Patentansprüche

1. MOS-Treiberschaltung mit einem ersten von einer ersten Treiberstufe und einem zweiten von einer zweiten Treiberstufe im Gegentakt in einen leitenden bzw. nichtleitenden Zustand gesteuerten Ausgangstransistor, an deren Verbindungspunkt eine zu treibende Last anschließbar ist, wobei zwischen einem Dateneingang und der ersten Treiberstufe eine erste Haltestufe und zwischen dem Dateneingang und der zweiten Treiberstufe eine zweite Haltestufe geschaltet sind, wobei die erste Haltestufe aufgrund eines von der zweiten Treiberstufe gelieferten Enable-Signals ein von dem Dateneingang kommendes Datensignal an die erste Treiberstufe weitergibt, und die zweite Haltestufe aufgrund eines von der ersten Treiberstufe gelieferten Enable-Signals das von dem Dateneingang kommende Datensignal an die zweite Treiberstufe weitergibt,
dadurch gekennzeichnet,
daß die erste und die zweite Treiberstufe (T1, T2) jeweils ein niederohmiges (NT1, NT2) und ein hochohmiges Treiberelement (HT1, HT2) umfassen, wobei die hochohmigen Treiberelemente (HT1, HT2) die Ausgangstransistoren (AT1, AT2) in den leitenden bzw. nichtleitenden Zustand überführen und die niederohmigen Treiberelemente (NT1, NT2) die Ausgangstransistoren (AT1, AT2) in dem nichtleitenden Zustand halten.

2. MOS-Treiberschaltung nach Anspruch 1, dadurch gekennzeichnet, daß die erste bzw. zweite Haltestufe (H1, H2) das Datensignal derart an die erste bzw. zweite Treiberstufe (T1, T2) weitergibt, daß der erste bzw. zweite Ausgangstransistor (AT1, AT2) erst dann in den leitenden Zustand übergeführt wird, wenn der zweite bzw. erste Ausgangstransistor (AT2, AT1) den nichtleitenden Zustand erreicht hat.

3. MOS-Treiberschaltung nach einem der vorangehenden Patentansprüche, dadurch gekennzeichnet, daß zwischen einem Ausgang der ersten bzw. zweiten Treiberstufe (T1, T2) und einem Eingang für das Enable-Signal der zweiten bzw. ersten Haltestufe (H1, H2) ein Schwellenelement (S1, S2) vorgesehen ist, welches das Enable-Signal (e1, e2) bei Erreichen eines bestimmten Spannungspegels der zweiten bzw. ersten Haltestufe (H2, H1) zuführt, sobald der erste/zweite Ausgangstransistor (AT1, AT2) in den nichtleitenden Zustand übergeführt ist.

4. MOS-Treiberschaltung nach einem der vorangehenden Ansprüche, dadurch gekennzeichnet, daß die Haltestufen (H1, H2) jeweils ein Flipflop enthalten, das die jeweiligen Treiberstufen nach Erreichen des nichtleitenden Zustandes des jeweiligen Ausgangstransistors im niederohmigen Zustand verriegelt.

5. MOS-Treiberschaltung nach einem der vorangehenden Patentansprüche, dadurch gekennzeichnet, daß an je einem Eingang der niederohmigen Treiberelemente (NT1, NT2) das Datensignal anliegt und einem Enable-Eingang des niederohmigen Treiberelements (NT1, NT2) der ersten bzw. zweiten Treiberstufe (T1, T2) das Ausgangssignal der zweiten bzw. ersten Haltestufe (H1, H2) zugeführt wird, daß es das jeweilige niederohmige Treiberelement (NT1, NT2) einschaltet, nachdem die Ausgangstransistoren (AT1, AT2) in den leitenden bzw. nichtleitenden Zustand überführt sind.

6. MOS-Treiberschaltung nach einem der vorangehenden Patentansprüche, dadurch gekennzeichnet, daß zwischen das Gate und das Drain eines Ausgangstransistors (AT1, AT2) ein Kondensator geschaltet ist.

## Claims

1. An MOS driver circuit comprising a first output transistor and a second output transistor which are driven in push-pull into a conducting or nonconducting state by a first driver stage and a second driver stage, respectively, and which are interconnected at a junction point to which a load to be driven is connectable, with a first hold stage connected between a data input and the first driver stage, and a second hold stage connected between the data input and the second driver stage, the first hold stage transferring a data signal coming from the data input to the first driver stage in response to an enable signal provided by the second driver stage, and the second hold stage transferring the data signal coming from the data input to the second driver stage in response to an enable signal provided by the first driver stage,
characterized in
that the first and second driver stages (T1, T2) each comprise a low-impedance driver element (NT1, NT2) and a high-impedance driver element (HT1, HT2), the high-impedance driver elements (HT1, HT2) driving the output transistors (AT1, AT2) into the conducting or nonconducting state, and the low-impedance driver elements (NT1, NT2) holding the output transistors (AT1, AT2) in the conducting state.

2. An MOS driver circuit as claimed in claim 1, characterized in that the first and second hold stages (H1, H2) transfer the data signal to the first and second driver stages (T1, T2), respectively, in such a way that the first and second output transistors (AT1, AT2) are not driven into the conducting state until the second and first output transistors (AT2, AT1), respectively, have reached the nonconducting state.

3. An MOS driver circuit as claimed in any one of the preceding claims, characterized in that two threshold elements (S1, S2) are provided, one (S1) between an output of the first driver stage (T1) and an enable-signal input of the second hold stage (H2) and the other (S2) between an output of the second driver stage (T2) and an enable-signal input of the first hold stage (H1), which, when a given voltage level is reached, apply the respective enable signals (e1, e2) to the second and first hold stages (H2, H1), respectively, as soon as the first or second output transistor (AT1, AT2) has been driven into the nonconducting state.

4. An MOS driver circuit as claimed in any one of the preceding claims, characterized in that each of the hold stages (H1, H2) contains a flip-flop which locks the respective driver stage in the low-impedance condition after the respective output transistor has reached the nonconducting state.

5. An MOS driver circuit as claimed in any one of the preceding claims, characterized in that the data signal is applied to one input of each of the low-impedance driver elements (NT1, NT2), that the output signals from the second and first hold stages (H2, H1) are applied to enable inputs of the low-impedance driver elements (NT1, NT2) of the first and second driver stages (T1, T2), respectively, so as to turn on the respective low-impedance driver element (NT1, NT2) after the output transistors (AT1, AT2) have been driven into the conducting or nonconducting state.

6. An MOS driver circuit as claimed in any one of the preceding claims, characterized in that a capacitor is connected between the gate and drain of one of the output transistors (AT1, AT2).

## Revendications

1. Circuit d'attaque du type MOS comportant un premier et un second transistors de sortie qui sont commandés de manière symétrique à l'état conducteur, respectivement à l'état non conducteur, par un premier, respectivement un second, étages d'attaque et au point de connexion desquels peut être raccordée une charge à attaquer, un premier et un second étages de maintien étant branchés entre une entrée de données et le premier, respectivement le second, étage d'attaque, le premier étage de maintien transmettant au premier étage d'attaque, à partir d'un signal de validation fourni par le second étage d'attaque, un signal de données provenant de l'entrée de données et le second étage de maintien transmettant au second étage d'attaque, à partir d'un signal de validation fourni par le premier étage d'attaque, le signal de données provenant de l'entrée de données,
caractérisé en ce que
les premier et second étages d'attaque (T1, T2) comprennent chacun un élément d'attaque de faible impédance (NT1, NT2) et un élément d'attaque de forte impédance (HT1, HT2), les éléments d'attaque de forte impédance (HT1, HT2) faisant passer les transistors de sortie (AT1, AT2) à l'état conducteur, respectivement non conducteur, et les éléments d'attaque de faible impédance (NT1, NT2) maintenant les transistors de sortie (AT1, AT2) à l'état non conducteur.

2. Circuit d'attaque du type MOS selon la revendication 1, caractérisé en ce que le premier, respectivement second, étage de maintien (H1, H2) transmet le signal de données au premier, respectivement second, élément d'attaque (T1, T2) de telle manière que le premier, respectivement second, transistor de sortie (AT1, AT2) ne passe à l'état conducteur que lorsque le second, respectivement premier, transistor de sortie (AT2, AT1) est parvenu à l'état non conducteur.

3. Circuit d'attaque du type MOS selon l'une quelconque des revendications précédentes, caractérisé en ce que, entre une sortie du premier, respectivement second, étage d'attaque (T1, T2) et une entrée pour le signal de validation du second, respectivement premier, étage de maintien (H1, H2), il est prévu un élément à seuil (S1, S2) qui envoie le signal de validation (e1, e2) lorsque l'on atteint un seuil de tension déterminé du second, respectivement premier, étage de maintien (H1, H2) aussitôt que le premier, respectivement second, transistor de sortie (AT1, AT2) est passé à l'état non conducteur.

4. Circuit d'attaque du type MOS selon l'une quelconque des revendications précédentes, caractérisé en ce que les étages de maintien (H1, H2) comprennent chacun une bascule bistable qui verrouille les étages d'attaque respectifs à l'état de faible impédance après que le transistor de sortie respectif soit passé à l'état non conducteur.

5. Circuit d'attaque du type MOS selon l'une quelconque des revendications précédentes, caractérisé en ce que, sur une entrée respective des éléments d'attaque à faible impédance (NT1, NT2), se trouve le signal de données et le signal de sortie du second, respectivement premier, étage de maintien (H1, H2) est envoyé à une entrée de validation de l'élément d'attaque à faible impédance (NT1, NT2) du premier, respectivement second, étage d'attaque (T1, T2) de telle sorte que le signal de sortie commute l'élément d'attaque à basse impédance respectif (NT1, NT2) après que les transistors de sortie (AT1, AT2) soient passés à l'état conducteur, respectivement à l'état non conducteur.

6. Circuit d'attaque du type MOS selon l'une quelconque des revendications précédentes, caractérisé en ce que, entre la grille et le drain d'un transistor de sortie (AT1, AT2) est branché un condensateur.
